# EUROPEAN PATENT APPLICATION

(11) **EP 4 734 359 A1**
(43) Date of publication of application: **29.04.2026**
(21) Application number: 24208011.7
(22) Date of filing: 22.10.2024
(51) Int. Cl.: H02P 29/024, G06N 20/00, H02P 23/14, H02P 23/00, G06N 3/02

(54) **METHOD OF MONITORING AN ELECTRICAL MACHINE**

(71) Applicant: ABB SCHWEIZ AG, 5400 Baden (CH)
(72) Inventor: KAKOSIMOS, Panagiotis, Västerås (SE); RÖNNBERG, Kristian, Köping (SE); PINTO, Cajetan, Madrid (ES)
(74) Representative: Kransell & Wennborg KB

(57) **Abstract**

A method of condition monitoring an electrical machine (11), the method comprising: a) obtaining a baseline of a monitored parameter of the electrical machine (11) from a machine learning model of the electrical machine (11) based on a set of measurement parameter values from sensors (13) arranged to measure parameters of the electrical machine (11) and on a set of electrical machine parameter values including electric drive configuration parameter values from an electric drive (15) controlling the electrical machine (11), b) obtaining a measurement of the monitored parameter, measured while controlling the electrical machine (11) with the electric drive (15) using the same electric drive configuration parameter values as in step a), c) comparing the measurement of the monitored parameter with the baseline, and d) determining that a fault is present in the electrical machine (11) in case the measurement of the monitored parameter deviates with more than a predetermined amount from the baseline.

## Description

### TECHNICAL FIELD

The present disclosure generally relates to electrical machines, and in particular to electrical machine condition monitoring.

### BACKGROUND

Electrical machines such as motors may be condition monitored using electrical machine models. In this way, unhealthy conditions may be detected. US 2021/0341901 A1 discloses condition monitoring in industrial environments. An embedded analytic engine for motor drives monitors induction motor conditions for potential failures including rotor faults and stator faults. A condition monitoring module is configured to obtain runtime signal data from a controller within a drive, derive runtime metrics from the runtime signal data based on an induction motor fault condition, provide the runtime metrics as input to a machine learning model constructed to identify a status of the induction motor based on the runtime metrics and output the status, and monitor the induction motor fault condition based on the status of the induction motor output by the machine learning model.

### SUMMARY

Motors may operate at different conditions such as speeds, loads, and ambient temperatures. In case the operating conditions change, existing solutions may in some cases not be able to detect mechanical failures of an electrical machine. For example, a healthy bearing at certain speed and load may generate a specific vibration level, at X root mean square (RMS) acceleration. If the bearing fails while the speed is reduced, an alarm may not be generated if the new vibration level for the faulty case with Y RMS acceleration is lower than that of the healthy baseline condition (X>Y) due to the reduced speed. Changing the load or operating temperatures also affects the effectiveness of known methods.

In view of the above, a general object of the present disclosure is to provide a method of monitoring an electrical machine which solves or at least mitigates the problems of the prior art.

There is hence according to a first aspect of the present disclosure provided a method of condition monitoring an electrical machine, the method comprising: a) obtaining a baseline of a monitored parameter of the electrical machine from a machine learning model of the electrical machine based on a set of measurement parameter values from sensors arranged to measure parameters of the electrical machine and on a set of electrical machine parameter values including electric drive configuration parameter values from an electric drive controlling the electrical machine, b) obtaining a measurement of the monitored parameter, measured while controlling the electrical machine with the electric drive using the same values as the electric drive configuration parameter values in step a), c) comparing the measurement of the monitored parameter with the baseline, and d) determining that a fault is present in the electrical machine in case the measurement of the monitored parameter deviates with more than a predetermined amount from the baseline.

It is thereby possible to identify if the behaviour of the mechanical components of the electrical machine is abnormal (or unexpected), and that a fault is present, regardless of the operating conditions of the electrical machine, determined by the electric drive configuration parameter values. The condition monitoring of the electrical machine thus becomes more accurate.

The fault may be a mechanical failure or mechanical fault of the electrical machine, such as a bearing fault, misalignment, soft foot also known as electrical machine distortion, i.e., that the electrical machine is not resting evenly on all feet, and imbalance.

The electrical machine may be a motor, such as an induction motor or a synchronous motor, or a generator.

The term "value" is to be understood to encompass a numerical, a Boolean value, or a categorical value.

According to one embodiment the set of electric drive configuration parameter values are values of electrical drive configuration parameters that include at least one of: control type, modulation technique, switching pulse pattern, switching frequency, PI gains, DC-link control, and offset in currents.

The control type involves the way the switching pattern of the electric drive is defined. It can be many different types in general, such as Scalar or Direct Torque Control (DTC).

According to one embodiment the set of electrical machine parameter values include at least one of a load of the electrical machine and a speed of the electrical machine.

According to one embodiment the machine learning model has been trained using the electric drive configuration parameter values of the set of electrical machine parameters. Thus, the machine learning model takes account of the current values of the electric drive configuration parameters when generating the baseline.

According to one embodiment in case the measurement of the monitored parameter deviates with more than the predetermined amount from the baseline, determining whether the set of electric drive configuration parameter values were used for training the machine learning model, and in case at least one value used for the training differs from a value of the set of electrical machine parameter values, alerting that the determining in step d) may potentially not be accurate. In case the machine learning model has not been trained with all possible values of electric drive configuration parameters, the method according to this example thus identifies this fact and provides an alert to an operator that the conclusion in step d) may potentially not be accurate because of the possible influence by differing electric drive configuration parameter values.

According to one embodiment the alerting comprises presenting all electric drive configuration parameters which has a value that differs from the electric drive configuration parameter values used for the training.

According to one embodiment the monitored parameter is one of vibration, flux, an internal motor temperature, and an external motor temperature. It has been found by the present inventors that the electric drive configuration parameter values of an electric drive directly impact the torque ripple, and as a result the vibration footprint. Thus, when vibration is the monitored parameter, the consideration of the electric drive configuration parameter values when in step d) assessing whether a fault is present or not is advantageous to achieve higher accuracy of the assessment. Additionally, it has been found that the drive configuration directly impacts the motor power losses, and as a result the motor thermal behaviour.

According to one embodiment the set of measurement parameter values are values of measurement parameters that include a speed of the electrical machine and an electrical machine frame temperature.

The measurement parameters may according to one example include acceleration.

The set of electrical machine parameter values may include speed of the electrical machine. The speed provided by the electric drive in the set of electrical machine parameter values is generally much more accurate at certain speeds, i.e., at low speeds, than speed estimation/measurement by the sensor(s). The difference in accuracy may be in the order of a hundred percent. If the set of electrical machine parameter values includes the speed of the electrical machine, then this value of the speed is used by the machine learning model instead of the speed provided by the sensor(s) to generate the baseline.

One embodiment comprises determining the predetermined amount dynamically based on the baseline.

According to one embodiment the determining of the predetermined amount involves adding an offset to and/or subtracting an offset from the baseline.

One embodiment comprises e) generating an alarm in the event that it is determined in step d) that a fault is present.

According to one embodiment the baseline reflects a healthy condition of the electrical machine for the set of electrical machine parameter values.

There is according to a second aspect of the present disclosure provided a computer code which when executed by processing circuitry of a condition monitoring system causes the condition monitoring system to perform the method of the first aspect.

There is according to a third aspect of the present disclosure provided a condition monitoring system for condition monitoring of an electrical machine, the condition monitoring system comprising: processing circuitry, and a storage medium comprising computer code according to the second aspect.

There is according to a fourth aspect of the present disclosure provided an electrical machine assembly comprising: an electrical machine, a plurality of sensors arranged to measure parameters of the electrical machine, an electric drive configured to control the electrical machine, and a condition monitoring system according to the third aspect, configured to obtain a set of measurement parameter values from the sensors and a set of electrical machine parameter values from the electric drive.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 schematically shows an example of a condition monitoring system for monitoring an electrical machine;
Fig. 2 shows an example of an electrical machine assembly; and
Fig. 3 is a flowchart of a method of condition monitoring an electrical machine by means of the condition monitoring system in Fig. 1.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

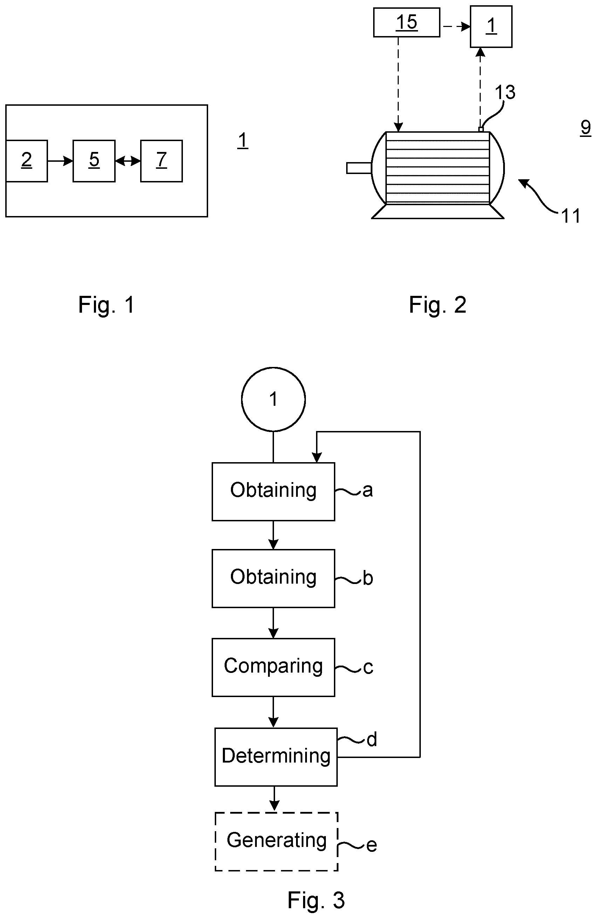

Fig. 1 depicts a block diagram of an example of a condition monitoring system 1. The condition monitoring system 1 is configured to monitor the condition of an electrical machine.

The condition monitoring system 1 comprises an input unit 2 configured to receive a set of measurement parameter values from sensors arranged to measure parameters of the electrical machine. The input unit 2 is configured to receive a set of electrical machine parameter values including electric drive configuration parameter values of electric drive configuration parameters from an electric drive that controls the electrical machine.

Each value of the set of measurement parameter values is a value of a respective parameter as detected or determined by the sensors.

Each value of the set of electrical machine parameter values is a current value of a respective parameter as provided from the electric drive.

The condition monitoring system 1 may be configured to receive the set of measurement parameter values and the set of electrical machine parameter values by wireless, wired, or a combination of wireless and wired communication from the sensors and from the electric drive, respectively.

The condition monitoring system 1 comprises processing circuitry 5 configured to receive the set of measurement parameter values and the set of electrical machine parameter values from the input unit 2.

The processing circuitry 5 may for example use any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations concerning the monitoring of an electrical machine.

The condition monitoring system 1 may comprise a storage medium 7. The storage medium 7 may comprise a computer program including computer code which when executed by the processing circuitry 5 causes the condition monitoring system 1 to perform the method as disclosed herein.

The storage medium 7 may for example be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory.

The condition monitoring system 1 may be a dedicated device e.g., arranged locally in the proximity of the electrical machine. Alternatively, the condition monitoring system 1 may be part of the cloud, with the set of measurement parameter values and the set of electrical machine parameter values being sent from the sensors and the electric drive, respectively, to the cloud for processing.

Fig. 2 schematically shows an electrical machine assembly 9. The electrical machine assembly 9 comprises an electrical machine 11 such as a motor or a generator.

The electrical machine assembly 9 comprises a plurality of sensors arranged to measure parameters of the electrical machine. Sensors may include one or more sensors 13 arranged to measure an electrical machine frame temperature of the electrical machine 11. Other sensors of the plurality of sensors may include one or more acceleration sensors/accelerometers, and/or a speed sensor.

The electrical machine assembly 9 also comprises the condition monitoring system 1.

The electrical machine assembly 9 furthermore comprises an electric drive 15 configured to control the electrical machine 11. The electric drive 15 may be a variable speed drive.

The electric drive 15 is configured to send a set of electrical machine parameter values of electrical machine parameters to the condition monitoring system 1. The set of electrical machine parameter values includes electric drive configuration parameter values. The electric drive configuration parameter values are values of electric drive configuration parameters that reflect the current configuration of the electric drive. The electric drive configuration parameters may for example include control type, modulation technique, switching pulse pattern, switching frequency, PI gains, DC-link control, and offset in currents. Any remaining parameter or parameters of the electrical machine parameters which are not electric drive configuration parameters is/are parameter(s) that reflects the current state of the electrical machine, for example speed, and/or load.

With reference to Fig. 3, a method of condition monitoring the electrical machine 11 by means of the condition monitoring system 1 will now be described.

In a step a) a baseline of a monitored parameter of the electrical machine is obtained from a machine learning model of the electrical machine 11. The baseline is obtained from the machine learning model based on a set of measurement parameter values received from the sensors and on a set of electrical machine parameter values including electric drive configuration parameter values received from the electric drive 15. The baseline is thus generated by the machine learning model based on the set of measurement parameter values and the set of electrical machine parameter values as input to the machine learning model.

The monitored parameter may for example be one of vibration, flux, an internal motor temperature, and an external motor temperature. The baseline may thus be an estimation of the vibration, the flux in the electrical machine 11, an internal motor temperature, or an external motor temperature, i.e. a temperature on the outer surface of the electrical machine 11, generated by the machine learning model.

The baseline reflects a healthy condition of the electrical machine 11 for the set of electrical machine parameter values.

The machine learning model may be trained by feeding the machine learning model with sets of electrical machine parameter values, preferably also including electric drive configuration parameter values, from an electric drive such as the electric drive 15, and with sets of measurement parameter values from the sensors.

In one example, the machine learning model has been trained using the same values of the set of electric drive configuration parameter values used for obtaining the baseline in step a).

When training the machine learning model, past behaviour of the electrical machine 11 may be taken into consideration by adding filtered or moving averaged versions of the electrical machine parameter values and of the measurement parameter values.

In one example, the RMS acceleration may be used for training the machine learning model. Other signals such as vibration and/or velocity may also be used.

In one example, residual networks may be employed to create the structure of the machine learning model.

In a step b) a measurement of the monitored parameter is obtained. The measurement of the monitored parameter may be obtained from one of the sensors 13 in real-time. The measurement of the monitored parameter is carried out while the electric drive 15 controls the electrical machine 11 with the same electric drive configuration parameter values as in step a). Thus, for example, the same control type, the same PI gains, and the same switching frequency is used both when the electrical machine 11 is controlled and the set of measurement parameter values is measured by the sensors and provided to the machine learning model for generating the baseline in step a) and when the measurement of the monitored parameter is carried out by one of the sensors and obtained in step b).

In a step c) the measurement of the monitored parameter is compared with the baseline. Thus, for example the vibration or flux as measured by one of the sensors is compared with the baseline. The baseline obtained from the machine learning model is an estimation of the vibration if the monitored parameter is vibration or a measure of the flux if the monitored parameter is the flux.

In a step d) it is determined that a fault is present in the electrical machine 11 in case the measurement of the monitored parameter deviates with more than a predetermined amount from the baseline.

In one example, in case the machine learning model has not been trained with all possible values of the electric drive configuration parameters in case the measurement of the monitored parameter deviates with more than the predetermined amount from the baseline, it is determined whether the set of electric drive configuration parameter values used in step a) were used for training the machine learning model. In case at least one value used for the training differs from an electric drive configuration parameter value of the set of electrical machine parameter values used in step a), the method may comprise generating an alert that the determining in step d) may potentially not be accurate. This is because at least one of the electric drive configuration parameter values differs from a value used for the training. Thus, it is not necessarily possible to conclude that a fault is present in this case even if the measurement of the monitored parameter deviates with more than the predetermined amount from the baseline. Conversely, it may not be possible to conclude that no fault is present even if the measurement of the monitored parameter does not deviate with more than a predetermined amount from the baseline. In one variation of this example, the alerting comprises presenting all electric drive configuration parameters used in step a) which has an electric drive parameter value that differs from an electric drive configuration parameter value used for the training of the machine learning model.

The predetermined amount may according to one example be determined dynamically based on the baseline. For example, the determining of the predetermined amount may involve adding an offset to and/or subtracting an offset from the baseline. In this way, a dynamic upper threshold value and a lower threshold value may be obtained, which changes in magnitude depending on the value of the baseline. Alternatively, the allowed deviation of the measurement of the monitored parameter from the baseline may be static, and the actual deviation may be determined e.g., by subtracting the measurement of the monitored parameter from the baseline at each instance in time.

In one example, an optional step e) is performed. Step e) comprises generating an alarm in the event that it is determined in step d) that a fault is present. The alarm may be visual e.g., presented on a display or it may be an aural alarm.

In one example, step e) may comprise generating a recommendation. For example, a recommendation may be to reduce the speed or load, or inspection the foundation of the electrical machine, or inspecting the bearings.

In one example, in case permission has been given, the electric drive 15 may be configured to control the electrical machine to reduce vibrations in case the monitored parameter is vibration.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. Method of condition monitoring an electrical machine (11), the method comprising:
a) obtaining a baseline of a monitored parameter of the electrical machine (11) from a machine learning model of the electrical machine (11) based on a set of measurement parameter values from sensors (13) arranged to measure parameters of the electrical machine (11) and on a set of electrical machine parameter values including electric drive configuration parameter values from an electric drive (15) controlling the electrical machine (11),
b) obtaining a measurement of the monitored parameter, measured while controlling the electrical machine (11) with the electric drive (15) using the same electric drive configuration parameter values as in step a),
c) comparing the measurement of the monitored parameter with the baseline, and
d) determining that a fault is present in the electrical machine (11) in case the measurement of the monitored parameter deviates with more than a predetermined amount from the baseline.

2. Method as claimed in claim 1, wherein the set of electric drive configuration parameter values are values of electrical drive configuration parameters that include at least one of: control type, modulation technique, switching pulse pattern, switching frequency, PI gains, DC-link control, and offset in currents.

3. Method as claimed in any of the preceding claims, wherein the set of electrical machine parameter values include at least one of a load of the electrical machine (11) and a speed of the electrical machine (11).

4. Method as claimed in any of the preceding claims, wherein the machine learning model has been trained using the set of electric drive configuration parameter values.

5. Method as claimed in any of the preceding claims, wherein in case the measurement of the monitored parameter deviates with more than the predetermined amount from the baseline, determining whether the set of electric drive configuration parameter values were used for training the machine learning model, and in case at least one value used for the training differs from a value of the set of electric drive configuration parameter values, alerting that the determining in step d) may potentially not be accurate.

6. Method as claimed in claim 5, wherein the alerting comprises presenting all electric drive configuration parameters which has a value that differs from the electric drive configuration parameter values used for the training.

7. Method as claimed in any of the preceding claims, wherein the monitored parameter is one of vibration, flux, an internal motor temperature, and an external motor temperature.

8. Method as claimed in any of the preceding claims, wherein the set of measurement parameter values are values of measurement parameters that include a speed of the electrical machine (11) and an electrical machine frame temperature.

9. Method as claimed in any of the preceding claims, comprising determining the predetermined amount dynamically based on the baseline.

10. Method as claimed in claim 9, wherein the determining of the predetermined amount involves adding an offset to and/or subtracting an offset from the baseline.

11. Method as claimed in any of the preceding claims, comprising e) generating an alarm in the event that it is determined in step d) that a fault is present.

12. Method as claimed in any of the preceding claims, wherein the baseline reflects a healthy condition of the electrical machine (11) for the set of electrical machine parameters.

13. Computer code which when executed by processing circuitry (5) of a condition monitoring system (1) causes the condition monitoring system (1) to perform the method of any of the preceding claims.

14. Condition monitoring system (1) for condition monitoring of an electrical machine (11), the condition monitoring system comprising:
processing circuitry (5), and
a storage medium (7) comprising computer code as claimed in claim 13.

15. Electrical machine assembly (9) comprising:
an electrical machine (11),
a plurality of sensors (13) arranged to measure parameters of the electrical machine (11),
an electric drive (15) configured to control the electrical machine (11), and
a condition monitoring system (1) as claimed in claim 14, configured to obtain a set of measurement parameter values from the sensors (13) and a set of electrical machine parameter values from the electric drive (15).
